# EUROPEAN PATENT APPLICATION

(11) **EP 3 672 385 A1**
(43) Date of publication of application: **24.06.2020**
(21) Application number: 18215316.3
(22) Date of filing: 21.12.2018
(51) Int. Cl.: H05K 9/00, G01R 29/08

(54) **SYSTEM AND METHOD FOR ADJUSTING ELECTROMAGNETIC COMPATIBILITY**

(71) Applicant: Vestel Elektronik Sanayi ve Ticaret A.S., 45030 Manisa (TR)
(72) Inventor: EGEMEN, Tufan, 45030 Manisa (TR); GÜRGEN, Engin, 45030 Manisa (TR)
(74) Representative: Flint, Adam

(57) **Abstract**

A system for adjusting EMC of an electronic device (10), e.g. a television set, comprising a casing (12) and at least one electronic board (17, 18) arranged within the casing (12), comprises a sensor unit (22) for detecting electromagnetic interference radiation outside the casing (12) of the respective electronic device (10). A control unit (20) evaluates the electromagnetic interference radiation detected by the sensor unit (22) and to adapts EMC properties of the at least one electronic board (17, 18) based on the evaluation results.

## Description

### Technical Field

The present disclosure relates to a system and a method for adjusting electromagnetic compatibility of an electronic device.

### Background

Electromagnetic compatibility (EMC) is a very important aspect on electronic device manufacturing. Generally, there are a lot of different kinds of signals on electronic boards having different frequencies in the range from kilohertz (kHz) to several gigahertz (GHz). Conventionally, the configuration and the software of the electronic boards of electronic devices and their isolations are modified to satisfy the respective EMC standards. Due to many different end user conditions and setups, however, it is very difficult or even impossible on the manufacturer side to check and modify the electronic devices for all possible end user conditions to meet the respective EMC criteria.

### Summary

According to a first aspect disclosed herein, there is provided a system for adjusting electromagnetic compatibility of an electronic device comprising a casing and at least one electronic board arranged within the casing, comprising a sensor unit configured to detect electromagnetic interference radiation outside the casing of the respective electronic device, and a control unit connected to the at least one electronic board of the respective electronic device and the sensor unit and configured to evaluate the electromagnetic interference radiation detected by the sensor unit and to adapt electromagnetic compatibility properties of the at least one electronic board based on the evaluation results.

The system including a sensor unit for detecting electromagnetic interference (EMI) radiation and a control unit for evaluating the detected EMI radiation and adapting electromagnetic compatibility (EMC) properties of the at least one electronic board based on the evaluation results provides a concept for automatically adjusting the EMC of a respective electronic device for all end user conditions or setups after the manufacturing process. In other words, the system can dynamically adapt the electronic board(s) to a new condition if the environment of the electronic device changes and dynamically improve the EMC performance of the electronic device for the new setup.

The system for adjusting EMC of an electronic device can be used for all electronic devices including at least one electronic board, especially mainboards and power boards, which must satisfy an EMC standard. The system can be used in particular for consumer electronics (televisions sets, etc.) and domestic appliances (refrigerators, freezers, washing machines, dryers, dishwashers, cookers, etc.).

The control unit may be e.g. a main processor of the electronic device. In case the at least one electronic board is arranged at or near a casing part, the sensor unit is preferably mounted on the same casing part, preferably a rear casing part of the electronic device.

In an example of the first aspect, the control unit is configured to distinguish frequencies and signal levels of the EMI radiation detected by the sensor unit. Preferably, the control unit is configured to identify the source of the detected EMI radiation frequencies (e.g. mainboard or power board).

In another example of the first aspect, the control unit is configured to perform at least one operation for the at least one electronic board selected from shifting frequencies, reducing signal levels and/or enabling spread spectrum mode.

In case of an electronic device having an electronic board provided with an EMC filter, in another example of the first aspect, the control unit is configured to also adapt the effects of said EMC filter.

According to a second aspect disclosed herein, a method for adjusting electromagnetic compatibility of an electronic device comprising a casing and at least one electronic board arranged within said casing comprises detecting electromagnetic interference radiation outside the casing of the respective electronic device; evaluating the detected electromagnetic interference radiation by a control unit connected to the at least one electronic board of the respective electronic device; and automatically adapting electromagnetic compatibility properties of the at least one electronic board by the control unit based on the evaluation results.

In an example of the second aspect, the evaluation comprises distinguishing frequencies and signal levels of the detected EMI radiation.

In an example of the second aspect, the adaption comprises checking signal levels of frequencies being EMC relevant for the respective electronic device.

In another example of the second aspect, the adaption comprises at least one operation for the at least one electronic board selected from shifting frequencies, reducing signal levels and/or enabling spread spectrum mode. In case the at least one electronic board is provided with an EMC filter, the adaption preferably also comprises adapting the effects of that EMC filter.

### Brief Description of the Drawings

To assist understanding of the present disclosure and to show how embodiments may be put into effect, reference is made by way of example to the accompanying drawings in which:
Figure 1 shows schematically the configuration of an example of an electronic device comprising a system for adjusting EMC according to the present disclosure; and
Figure 2 shows schematically an example of a flowchart of a system for adjusting EMC according to the present disclosure.

### Detailed Description

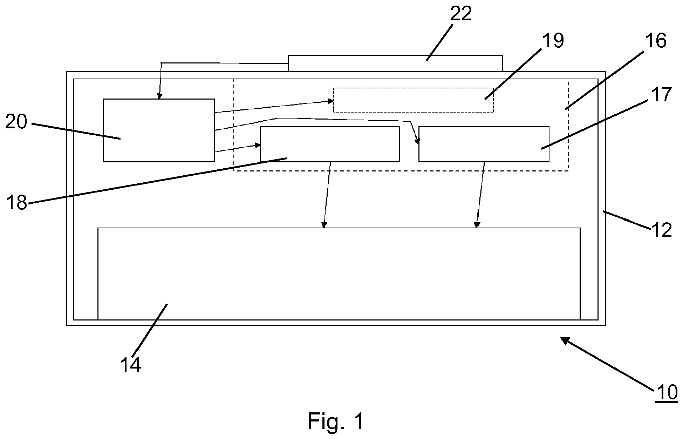

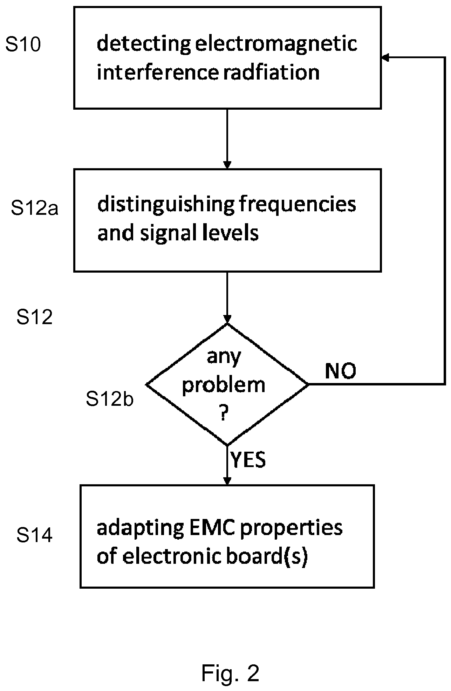

Figures 1 and 2 show an exemplary embodiment of an electronic device including a system for adjusting EMC and performing a method for adjusting EMC according to an example of the present disclosure. In this embodiment, the electronic device is a television set although the present disclosure is not limited to this application. For example, the electronic device may alternatively be a display screen or panel, a PVR (personal video recorder, also known as a DVR or digital video recorder), a DVD player, a Blu Ray player, a set-top box, a desktop or laptop or tablet computer, etc., a video game console, a cellular phone (including a so-called "smart phone"), a media player, a printer, an electric appliance such as a "white goods" item such as a washing machine, a tumble dryer, a combined washing machine and tumble dryer, a dishwasher, a refrigeration apparatus such as a fridge or freezer or combined fridge-freezer, etc., etc.

The television set 10 has a machine casing 12. At the front part of the casing 12 facing towards a user (bottom side of Figure 1), there is arranged a display unit 14 within the casing 12. At the rear part of the casing 12 (top side of Figure 1), there is arranged a driving circuit 16 within the casing 12. This driving circuit 16 comprises a power board 17 for supplying electric power to the display unit 14 and a mainboard 18 for driving the display unit 14. The power board 17 and the mainboard 18 are electronic boards in the meaning of the present disclosure.

Preferably, the driving circuit 16 is also provided with an EMC isolation (not shown) for shielding the driving circuit 16.

Further, the television set 10 comprises a control unit 20 for controlling the driving circuit 16. The control unit 20 may be e.g. a main processor of the television set 10.

The television set 10 also comprises a system for adjusting its EMC according to the respective end user conditions. This system comprises the above-mentioned control unit 20 and a sensor unit 22. The sensor unit 22 is arranged outside the casing 12 of the television set 10, especially at the same casing part as the driving circuit 16. This sensor unit 22 is configured to detect EMI radiation outside the casing 12 of the television set 10, in particular EMI radiation generated by the power board 17 and the mainboard 18 of the driving circuit 16 within the casing 12. The sensor unit 22 may be formed as a near-field sensor block. The sensor unit 22 especially checks all frequencies which are relevant for the respective EMC standard.

The control unit 20 is connected (wired or wireless) to the sensor unit 22 to receive the measurement signals of the sensor unit 22. The control unit 20 is configured to evaluate the EMI radiation signals detected by the sensor unit 22. This evaluation especially includes distinguishing the frequencies and signal levels of the detected EMI radiation, identifying the source of EMI radiation (i.e. generated by mainboard 18 or power board 17), and judging whether there is a problem as to the respective EMC standard.

Further, the control unit 20 is configured to adapt the EMC properties of the driving circuit 16, especially the mainboard 18 of the driving circuit 16, depending on the results of the evaluation process. The EMC properties may be adapted by e.g. shifting a frequency to a different frequency, reducing signal levels e.g. by decreasing frequency gain and/or enabling spread spectrum mode for the mainboard 16.

Optionally, the driving circuit 16 may be also provided with an EMC filter 19 for filtering EMI radiation generated by the driving circuit 16, in particular the electronic boards 17, 18 and lines of the driving circuit. The EMC filter 19 may be a passive EMC filter or an active EMC filter. Preferably, the EMI filtering properties of this EMC filter 19 can be adjusted or adapted by the control unit 20. In this example, the control unit 20 is preferably configured to also adapt the effects of the EMC filter for adapting the EMC properties of the driving circuit 16.

Figure 2 schematically shows the corresponding method for adjusting the EMC of the television set 10 using the above-described configuration.

At S 10, the EMI radiation is detected by the sensor unit 22. Thereafter, the detected EMI radiation is evaluated by the control unit at S 12. This evaluation S 12 includes distinguishing the frequencies and signal levels of the detected EMI radiation at S 12a and judging whether there is a problem as to the respective EMC standard at S12b.

If there is no EMC problem (NO at S 12b), the process is continued with detection at S 10. However, if the control unit 20 determines that there exists an EMC problem with the present configuration and software of the driving circuit 16 (YES in step S12b), the control unit 20 proceeds to S14. At S14, the control unit 20 adapts the EMC properties of the mainboard 16 and, if existing, the EMC filter 19 of the driving circuit is adjusted or adapted in the way discussed above, i.e. by shifting frequencies, reducing signal levels and/or enabling spread spectrum mode for the mainboard 18 and/or adapting effects of the EMC filter 19. Thus, the system checks the EMC performance of the television set 10, especially the driving circuit 16 thereof, and improves the overall performance adaptively.

For example, sometimes the power board 17 and the mainboard 18 both generate signals having the same frequency. In this case, exemplarily, the control unit 20 will either shift the frequency, enable spread spectrum or reduce the signal level at the mainboard side to improve EMC performance. If the signal level is still too high for that frequency, the control unit 20 may check the specific block of the frequencies and turn off that block in case the active source does not use that block.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. A system for adjusting electromagnetic compatibility of an electronic device (10) comprising a casing (12) and at least one electronic board (17, 18) arranged within said casing (12), comprising:
a sensor unit (22) configured to detect electromagnetic interference radiation outside said casing (12) of the respective electronic device (10); and
a control unit (20) connected to said at least one electronic board (17, 18) of the respective electronic device (10) and said sensor unit (22) and configured to evaluate the electromagnetic interference radiation detected by said sensor unit (22) and to adapt electromagnetic compatibility properties of said at least one electronic board (17, 18) based on the evaluation results.

2. The system of claim 1, wherein said at least one electronic board (17, 18) comprises a mainboard (18) and a power board (17).

3. The system of claim 1 or claim 2, wherein said control unit (20) is configured to distinguish frequencies and signal levels of the electromagnetic interference radiation detected by said sensor unit (22).

4. The system of any of claims 1 to 3, wherein said control unit (20) is configured to perform at least one operation for said at least one electronic board (17, 18) selected from shifting frequencies, reducing signal levels and/or enabling spread spectrum mode.

5. The system of any of claims 1 to 4, wherein said at least one electronic board (17, 18) of the respective electronic device (10) is provided with an EMC filter (19) and said control unit (20) is configured to adapt the effects of said EMC filter (19).

6. A method for adjusting electromagnetic compatibility of an electronic device (10) comprising a casing (12) and at least one electronic board (17, 18) arranged within said casing (12), comprising:
detecting (S10) electromagnetic interference radiation outside said casing (12) of the respective electronic device (10);
evaluating (S12) the detected electromagnetic interference radiation by a control unit (20) connected to said at least one electronic board (17, 18) of the respective electronic device (10); and
automatically adapting (S14) electromagnetic compatibility properties of said at least one electronic board (17, 18) by said control unit (20) based on the evaluation results.

7. The method of claim 6, wherein the evaluation (S12) comprises distinguishing (S12a) frequencies and signal levels of the detected electromagnetic interference radiation.

8. The system of claim 6 or claim 7, wherein the adaption (S14) comprises checking (S12b) signal levels of frequencies being EMC relevant for the respective electronic device (10).

9. The system of any of claims 6 to 8, wherein the adaption (S14) comprises at least one operation for said at least one electronic board (17, 18) selected from shifting frequencies, reducing signal levels and/or enabling spread spectrum mode.

10. The system of any of claims 6 to 9, wherein said at least one electronic board (17, 18) is provided with an EMC filter (19) and the adaption (S14) comprises adapting the effects of said EMC filter (19).
